# EUROPÄISCHE PATENTANMELDUNG

(11) **EP 0 660 125 A2**
(43) Veröffentlichungstag der Anmeldung: **28.06.1995**
(21) Anmeldenummer: 94116970.8
(22) Anmeldetag: 27.10.1994
(51) Int. Cl.: G01R 31/12

(54) **Verfahren zur Funktionsprüfung von steckbaren Überspannungsableitern für elektrische Anlagen**

(30) Priorität: 24.12.1993 DE 4344443
(71) Anmelder: OBO Bettermann OHG, D-58710 Menden (DE)
(72) Erfinder: Trinkwald, Jürgen, Dipl.-Ing., D-58708 Menden (DE); Rodenwald, Frank, Dipl.-Ing., D-58710 Menden (DE)
(74) Vertreter: Patentanwälte Dipl.-Ing. Conrad Köchling Dipl.-Ing. Conrad-Joachim Köchling

(57) **Zusammenfassung**

Um ein Verfahren zur Funktionsprüfung von steckbaren Überspannungsableitern für elektrische Anlagen, wobei die Überspannungsableiter ein Gehäuse mit innenliegenden Varistoren als Überspannungsschutzelement sowie eine Defektanzeige und aus dem Gehäuse herausgeführte Kontaktstifte oder dergleichen Kontaktelemente aufweisen, die mit dem Überspannungsschutzelement in Verbindung stehen, wobei nach der Endmontage der Einzelbauteile eine elektrische Prüfung auf Funktionsfähigkeit des Überspannungsableiters durchgeführt wird, indem die Kontaktelemente an einen Stromkreis angeschlossen werden und bei einem Prüfstrom im Bereich geringer Stromstärke (mA) die Durchgangsspannung gemessen und der erhaltene Wert der Durchgangsspannung mit einem Toleranzfeld der Soll-Durchgangsspannung verglichen wird, zu schaffen, mittels dessen eine genaue Erfassung und Überprüfung von Funktionsprüfungen möglich wird, wird vorgeschlagen, daß am Gehäuse oder damit verbundenen Teilen des Überspannungsableiters der erfaßte Wert der Durchgangsspannung und die Prüfstromstärke ablesbar abgelegt ist.

## Beschreibung

Die Erfindung betrifft ein Verfahren zur Funktionsprüfung von steckbaren Überspannungsableitern für elektrische Anlagen, wobei die Überspannungsableiter ein Gehäuse mit innenliegenden Varistoren als Überspannungsschutzelement sowie eine Defektanzeige und aus dem Gehäuse herausgeführte Kontaktstifte oder dergleichen Kontaktelemente aufweisen, die mit dem Überspannungsschutzelement in Verbindung stehen, wobei nach der Endmontage der Einzelbauteile eine elektrische Prüfung auf Funktionsfähigkeit des Überspannungsableiters durchgeführt wird, indem die Kontaktelemente an einen Stromkreis angeschlossen werden und bei einem Prüfstrom im Bereich geringer Stromstärke (mA) die Durchgangsspannung gemessen und der erhaltene Wert der Durchgangsspannung mit einem Toleranzfeld der Soll-Durchgangsspannung verglichen wird.

Steckbare Überspannungsableiter sind beispielsweise durch die DE 40 00 272.1 und die DE 40 02 237.2 A1 bekannt.
Bisher ist es üblich, daß solche Überspannungsableiter nach deren Herstellung auf ordnungsgemäße Funktion überprüft werden, wobei bei einem Stromdurchgang von beispielsweise 1 mA die Durchgangsspannung in Volt gemessen wird. Dieser erfaßte Meßwert wird mit einem vorgegebenen Toleranzfeld der Durchgangsspannung verglichen. Sofern der Meßwert innerhalb des Toleranzfeldes liegt, ist der Überspannungsableiter in Ordnung und erhält die Lieferfreigabe. Sofern der erfaßte Meßwert außerhalb des Toleranzfeldes liegt, wird der Überspannungsableiter nicht freigegeben und beispielsweise dem Ausschuß zugeführt. Solche Überspannungsableiter werden in hoher Stückzahl benötigt. Es ist für den Hersteller später nach auftretenden Schadensfällen oder Reklamationen nicht nachvollziehbar, ob beispielsweise Überspannungsableiter mit einem bestimmten Fertigungsdatum Funktionsfehler aufweisen oder defektanfällig sind. Sofern solche im Gebrauch befindliche Überspannungsableiter reklamiert werden, hat der Hersteller nur die Möglichkeit, diese zu ersetzen und gegebenenfalls auch die reklamierten oder defekten Überspannungsableiter zu überprüfen, um Ursachen festzustellen. Jedoch ist eine Quellensuche für Defektfälle nicht auf bestimmte Fertigungsperioden oder dergleichen umsetzbar, welches es dem Hersteller ermöglicht, eine genaue Zuordnung von Überspannungsableitern und Fertigungszeiträumen und Vorgängen zustande zu bringen.

Zur Lösung dieser Aufgabe wird vorgeschlagen, daß am Gehäuse oder damit verbundenen Teilen des Überspannungsableiters der erfaßte Wert der Durchgangsspannung und die Prüfstromstärke ablesbar abgelegt wird.

Dadurch, daß am Gehäuse oder damit verbundenen Teilen des Überspannungsableiters der erfaßte Wert der Durchgangsspannung und auch die Prüfungsstromstärke ablesbar abgelegt wird, ist es sowohl für den Anwender als auch vorallem für den Hersteller möglich, jederzeit bei einer erneuten Überprüfung des Überspannungsableiters festzustellen, ob die ursprünglich erfaßten Testwerte noch mit den tatsächlichen Testwerten übereinstimmen oder nicht. Selbst bei Abweichungen, die dann noch innerhalb des Toleranzfeldes liegen, ist feststellbar, ob und gegebenenfalls wie sich die Funktion des Überspannungsableiters gegenüber dem ursprünglichen Testdatum verändert hat. Hierdurch können wesentliche Erkenntnisse bezüglich der Alterung oder auch bezüglich eventuell auftretender Schadensfälle gewonnen werden.

Um eine noch bessere Zuordnung auch zu bestimmten Herstellungsdaten und Prüfdaten zu ermöglichen, wird ergänzend vorgeschlagen, daß auch das Prüfungsdatum und/oder Herstellungsangaben ablesbar am Gehäuse abgelegt werden.

Das ablesbare Ablegen von Daten kann beispielsweise über elektrisch erfaßbare oder magnetisch erfaßbare Codierungen oder auch optisch mittels Lesegerät erfaßbare Codierungen erfolgen.

Bevorzugt ist ferner vorgesehen, daß dann, wenn die erfaßte Durchgangsspannung außerhalb des vorgegebenen Toleranzfeldes liegt, eine die Unbrauchbarkeit des Überspannungsableiters angebende Anzeige ablesbar am Gehäuse abgelegt wird.

Durch diese eindeutige Kennzeichnung ist es möglich, unbrauchbare Überspannungsableiter eindeutig zu identifizieren, ohne daß diese zufällig oder ungewollt einer bestimmungsgemäßen Benutzung zugeführt werden.

Besonders bevorzugt ist vorgesehen, daß die Prüfwerte oder sonstigen Angaben optisch ablesbar auf der Gehäuseaußenwandung abgelegt werden.

Zur Vereinfachung der Handhabung ist besonders vorteilhaft, daß die Prüfwerte oder sonstigen Angaben optisch ablesbar nicht codiert auf die Gehäuseaußenwandung aufgedruckt werden.

Hierdurch ist es für den Benutzer in einfachster Weise ohne Zuhilfenahme von zusätzlichen Geräten möglich, die entsprechenden Daten abzulesen und zu erfassen.

Eine besonders vorteilhafte verfahrenstechnische Weiterbildung wird darin gesehen, daß der Überspannungsableiter in bestimmten oder unbestimmten periodischen oder nichtperiodischen Zeiträumen mit einem dem Prüfstromdurchgang entsprechenden sekundären Prüfstromdurchgang hinsichtlich der tatsächlichen Durchgangsspannung überprüft wird und der erhaltene sekundäre Meßwert der Durchgangsspannung mit dem am Gehäuse abgelegten ursprünglichen verglichen wird.

Durch die erfindungsgemäße Kennzeichnung ist es möglich, solche Überspannungsableiter in beliebigen Zeiträumen erneut einem Test zu unterziehen, wobei anhand eines Vergleichs der abgelegten Daten und der tatsächlich gemessenen Daten Unterschiede festgestellt und entsprechende Konsequenzen gezogen werden können. Beispielsweise besteht für den Anwender die Möglichkeit, schon frühzeitig vor einem Ausfall eines Überspannungsableiters festzustellen, daß dieser aufgrund erheblich abweichender Testergebnisse zwischen ursprünglichem Test und tatsächlichem Test möglicherweise schon bald nicht mehr funktionsfähig ist, so daß dieser Überspannungsableiter frühzeitig ausgetauscht werden kann, ohne daß es erst zu einem Ausfall des Überspannungsableiters kommen muß. Ein Ausfall eines Überspannungsableiters beispielsweise durch ein entsprechendes Spannungsereignis wird durch die dann in Funktion tretende Defektanzeige angezeigt. Solche Defektanzeigen sind im Stand der Technik üblich und bekannt.

## Patentansprüche

1. Verfahren zur Funktionsprüfung von steckbaren Überspannungsableitern für elektrische Anlagen, wobei die Überspannungsableiter ein Gehäuse mit innenliegenden Varistoren als Überspannungsschutzelement sowie eine Defektanzeige und aus dem Gehäuse herausegeführte Kontaktstifte oder dergleichen Kontaktelemente aufweisen, die mit dem Überspannungsschutzelement in Verbindung stehen, wobei nach der Endmontage der Einzelbauteile eine elektrische Prüfung auf Funktionsfähigkeit des Überspannungsableiters durchgeführt wird, indem die Kontaktelemente an einen Stromkreis angeschlossen werden und bei einem Prüfstrom im Bereich geringer Stromstärke (mA) die Durchgangsspannung gemessen und der erhaltene Wert der Durchgangsspannung mit einem Toleranzfeld der Soll-Durchgangsspannung verglichen wird, **dadurch gekennzeichnet,** daß am Gehäuse oder damit verbundenen Teilen des Überspannungsableiters der erfaßte Wert der Durchgangsspannung und die Prüfstromstärke ablesbar abgelegt ist.

2. Verfahren nach Anspruch 1, **dadurch gekennzeichnet,** daß auch das Prüfungsdatum und/oder Herstellerangaben ablesbar am Gehäuse abgelegt werden.

3. Verfahren nach Anspruch 1 oder 2, **dadurch gekennzeichnet,** daß dann, wenn die erfaßte Durchgangsspannung außerhalb des vorgegebenen Toleranzfeldes liegt, eine die Unbrauchbarkeit des Überspannungsableiters angebende Anzeige ablesbar am Gehäuse abgelegt wird.

4. Verfahren nach einem der Ansprüche 1 bis 3, **dadurch gekennzeichnet**, daß die Prüfwerte oder sonstigen Angaben optisch ablesbar auf der Gehäuseaußenwandung abgelegt werden.

5. Verfahren nach Anspruch 4, **dadurch gekennzeichnet**, daß die Prüfwerte oder sonstigen Angaben nicht codiert optisch ablesbar auf die Gehäuseaußenwandung aufgedruckt werden.

6. Verfahren nach einem der Ansprüche 1 bis 5, **dadurch gekennzeichnet**, daß der Überspannungsableiter in bestimmten oder unbestimmten periodischen oder nichtperiodischen Zeiträumen mit einem dem Prüfstromdurchgang entsprechenden sekundären Prüfstromdurchgang hinsichtlich der tatsächlichen Durchgangsspannung überprüft wird und der erhaltene sekundäre Meßwert der Durchgangsspannung mit dem am Gehäuse abgelegten ursprünglichen verglichen wird.
